# FASCICULE DE BREVET EUROPEEN

(11) **EP 0 655 176 B1**
(45) Date de publication et mention de la délivrance du brevet: **29.04.1998**
(21) Numéro de dépôt: 93917861.2
(22) Date de dépôt: 10.08.1993
(51) Int. Cl.: H03F 1/32, H03F 3/45

(54) **ETAGE AMPLIFICATEUR A FAIBLE DISTORSION THERMIQUE**
VERSTÄRKERSTUFE MIT GERINGER THERMISCHER VERZERRUNG
AMPLIFIER STAGE WITH LOW THERMAL DISTORTION

(30) Priorité: 11.08.1992 FR 9209903
(43) Date de publication de la demande: 31.05.1995
(73) Titulaire: PERROT, Gérard, 92120 Montrouge (FR)
(72) Inventeur: PERROT, Gérard, 92120 Montrouge (FR)
(74) Mandataire: Beauchamps, Georges
(86) Numéro de dépôt international: FR9300802
(87) Numéro de publication internationale: WO9405079

(56) Documents cités:
- EP-A- 0 156 410
- US-A- 4 757 274
- IEEE INTERNATIONAL SOLID STATE CIRCUITS CONFERENCE DIGEST OF TECHNICAL PAPERS vol. 18, no. 18 , Février 1975 , NEW YORK US pages 196 - 197 M. TIMKO ET AL 'AN IMPROVED MONOLITHIC INSTRUMENTATION AMPLIFIER'
- IEEE INTERNATIONAL SOLID STATE CIRCUITS CONFERENCE vol. 18, no. 18 , Février 1975 , NEW YORK US pages 194 - 195 R.J. VAN DE PLASSCHE 'A WIDEBAND MONOLITHIC INSTRUMENTATION AMPLIFIER'
- ELECTRONIC ENGINEERING vol. 55, no. 677 , Mai 1983 , LONDON GB pages 35 - 39 G. STOCCHINO 'LOW DISTORTION AMPLIFIER FOR INSTRUMENTATION'
- EDN ELECTRICAL DESIGN NEWS. vol. 28, no. 16 , Aoüt 1983 , NEWTON, MASSACHUSETTS US pages 173 - 180 A METZ 'CIRCUIT-DESIGN/PROCESS COMBO SPEEDS HORIZONTAL-AMP SLEWING'

## Description

La présente invention concerne un étage amplificateur du type comprenant au moins un premier transistor dont la base constitue une borne d'entrée pour un signal d'entrée amplifié et un moyen pour maintenir un courant sensiblement constant dans le trajet collecteur-émetteur du transistor.

Les circuits audio utilisent beaucoup les étages différentiels en particulier comme étages d'entrée des circuits amplificateurs. Le circuit le plus utilisé est le circuit différentiel à deux transistors, mais sa linéarité qui résulte de la fonction de transfert des deux transistors est limitée dès que les signaux amplifiés ont une certaine amplitude. Pour remédier à ce problème, de nombreux circuits ont déjà été proposés pour obtenir des circuits différentiels plus linéaires dans un cadre plus général que le traitement des signaux audio. C'est en particulier le cas du circuit de l'art antérieur tel que mentionné dans le paragraphe ci-dessus.

Ces circuits souffrent d'un autre défaut pénalisant plus particulièrement les circuits audio : la distorsion d'origine thermique. En effet, la fonction de transfert de ces circuits est liée aux caractéristiques des transistors utilisés. Celles-ci sont fonction des températures de leur jonction. Or, ces températures sont non seulement fonction des conditions thermiques environnantes, mais également de la puissance instantanée dissipée dans les jonctions elles-mêmes. Cette puissance dépend de l'amplitude du signal injecté : dans le cas des signaux audio, l'amplitude varie souvent à l'échelle d'environ une dizaine de millisecondes, qui est l'ordre de grandeur de la constante de temps thermique des jonctions des transistors.

Dans les circuits usuels, les fonctions de transfert des circuits sont donc modulées par les variations d'amplitude des signaux traités. Dans le cas des signaux audio, ce problème est très pernicieux non seulement parce que les constantes de temps de ces variations ont le même ordre de grandeur que les constantes de temps des variations de niveaux des signaux traités mais aussi parce que l'oreille est sensible à ces variations qui échappent aux mesures faites classiquement sur des signaux d'amplitude stable.

L'idée de base de l'invention est de stabiliser la fonction de transfert d'un étage amplificateur en stabilisant la puissance dissipée dans le ou les transistor(s) les plus critique(s) pour la définition de la fonction de transfert.

L'invention concerne ainsi un étage amplificateur comprenant au moins un module présentant un premier transistor d'un premier type de conductivité dont la base constitue une borne d'entrée pour un signal d'entrée à amplifier et un moyen pour maintenir un courant sensiblement constant dans le trajet collecteur-émetteur du premier transistor (celui-ci étant utilisé soit en émetteur suiveur, soit en émetteur commun, en particulier dans un étage différentiel), et comportant un circuit de contre-réaction présentant un trajet de courant principal entre une première borne active de l'étage et l'émetteur du premier transistor, caractérisé en ce que ledit moyen est constitué par une première source de courant connectée au collecteur du premier transistor et en ce que le circuit de contre-réaction est agencé de manière telle que la valeur dudit courant principal est fonction de la différence entre la tension d'une source de tension de référence et le potentiel du collecteur du premier transistor, le gain (transconductance) du circuit de contre-réaction étant choisi de manière telle que le potentiel du collecteur du premier transistor soit sensiblement constant et la tension de la source de tension de référence n'étant pas liée à la tension d'alimentation et étant choisie de manière telle que le premier transistor fonctionne à tension collecteur-base sensiblement constant, de préférence à tension collecteur-base peu élevée, en particulier inférieure à 1 V.

Le courant à travers le trajet du collecteur-émetteur du premier transistor étant fixé par la source de courant et d'autre part, son potentiel de collecteur variant peu puisque, par rapport à l'art antérieur, les variations de ce potentiel sont réduites par l'action du circuit de contre-réaction, le transistor travaille à puissance dissipée sensiblement constante et donc à une température sensiblement égale à la température ambiante d'où une quasi-suppression de l'effet de modulation de sa caractéristique de transfert par le signal d'entrée. En outre, la tension base-émetteur du premier transistor est sensiblement constante et n'influe pas sur son gain ni sur sa linéarité.

Selon un mode de réalisation préféré du circuit de contre-réaction selon lequel le potentiel du collecteur du premier transistor est déterminé par le potentiel de la source de tension de référence et par des tensions base-émetteur de transistors, le trajet de courant principal du circuit de contre-réaction comporte un deuxième transistor d'un deuxième type de conductivité opposé au premier type de conductivité, dont le collecteur est connecté à l'émetteur du premier transistor, dont la base est connectée au collecteur du premier transistor, dont l'émetteur est connecté à l'émetteur d'un troisième transistor d'un premier type de conductivité, dont la base est connectée à ladite source de tension de référence et dont le collecteur constitue ladite borne active de l'étage. Les distorsions thermiques des deuxième et troisième transistors ont peu d'effet sur le montage ainsi qu'il sera montré ci-après.

La première source de courant peut comporter une borne de commande de courant, une première résistance étant connectée entre la borne de commande et la base du deuxième transistor.

La première source de courant peut être découplée par un quatrième transistor du deuxième type de conductivité dont la base est connectée à celle du troisième transistor, dont le collecteur est connecté au collecteur du premier transistor et dont l'émetteur est connecté à ladite première source de courant.

Selon une première variante, ladite borne de l'étage est une borne d'alimentation en tension de l'étage et l'étage amplificateur est du type émetteur suiveur. Le circuit peut alors comporter un circuit de commande destiné à asservir la valeur de la tension de la source de tension de référence en fonction de la tension d'émetteur ou de base du premier transistor, c'est-à-dire en fonction de la tension de sortie ou d'entrée de l'étage.

Selon une deuxième variante, l'étage amplificateur comporte deux modules tels que définis ci-dessus, les émetteurs du premier transistor de chaque module étant couplés de préférence par une résistance pour former un étage différentiel, les bornes actives des deux modules constituant des sorties de l'étage différentiel.

Selon un mode de réalisation préféré de l'étage amplificateur différentiel les variations de la puissance dissipée dans les transistors d'entrée de l'étage différentiel en fonction d'une tension éventuelle de mode commun des signaux d'entrée sont au moins en majeure partie supprimées par un circuit de compensation destiné à décaler la valeur de la tension de la source de tension de référence en fonction de la tension de mode commun de l'étage différentiel. Le circuit de compensation peut en particulier comporter un pont de résistances présentant un point milieu dont la tension est une moyenne pondérée, éventuellement la moyenne arythmétique entre les tensions d'émetteurs du premier transistor des deux modules, et il présente un cinquième transistor monté en émetteur suiveur ainsi qu'un générateur de tension constante disposés en série entre le point milieu et la base d'un sixième transistor dont l'émetteur délivre ladite tension de la source de tension de référence.

D'autres caractéristiques et avantages de l'invention seront mieux compris à la lecture de la description qui va suivre, donnée à titre d'exemple non limitatif, en liaison avec les dessins qui représentent :
- les figures 1 à 3, les étages différentiels selon l'art antérieur, respectivement un étage différentiel simple, un étage différentiel à émetteurs couplé par des résistances, et un étage différentiel à linéarité améliorée,
- la figure 4, un premier mode de réalisation de l'invention,
- les figures 5, 6 et 7, des variantes de ce mode de réalisation,
- la figure 8, un mode préférentiel de l'invention comportant un circuit de compensation de mode commun dont un mode de réalisation particulier est donné à la figure 9,
- la figure 10, un étage amplificateur selon l'invention pour un fonctionnement en émetteur suiveur.

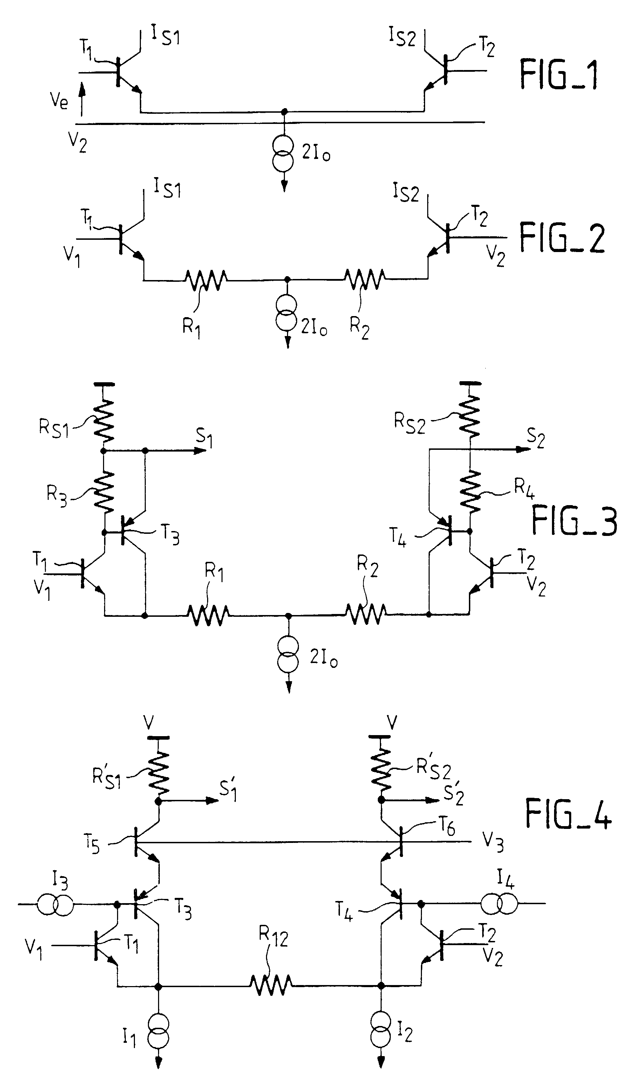

La figure 1 représente un étage différentiel simple, dans lequel les émetteurs de deux transistors T₁ et T₂ sont couplés directement et connectés à une source de courant d'intensité 2I₀. Les bases des transistors T₁, T₂ reçoivent des tensions d'entrée, respectivement V₁, V₂ et leurs collecteurs délivrent des courants de sortie I_{S1} et I_{S2}.

Il est classique d'augmenter la linéarité de ce montage en disposant en série des résistances R₁ et R₂ entre les émetteurs des transistors T₁ et T₂ et la source de courant d'intensité 2I₀. Il est également classique d'adjoindre à un tel montage, une cascode, le montage cascode ayant pour avantage de diminuer la distorsion due aux capacités collecteur-base des premier et deuxième transistors T₁ et T₂ formant l'étage différentiel (compensation de l'effet Miller).

A la figure 3 on a représenté un montage connu permettant d'améliorer la linéarité grâce à des transistors T₃ et T₄ du type opposé aux transistors T₁ et T₂ et montés en contre-réaction pour en fixer de manière sensiblement constante le courant à travers le trajet collecteur-émetteur des transistors T₁ et T₂. Ce montage comporte donc un transistor T₃ dont la base est connectée au collecteur du transistor T₁, dont le collecteur est connecté à l'émetteur du transistor T₁ une résistance R₃ étant disposée entre la base et l'émetteur du transistor T₃. L'émetteur de T₃ constitue une sortie S₁ du circuit. Une résistance de sortie R_{S1} connectée entre la sortie S₁ et une source de tension d'alimentation V permet d'obtenir une sortie en tension de l'étage différentiel. De la même façon, un transistor T₄ du type pnp opposé à celui-ci (npn) du transistor T₂ a sa base connectée au collecteur du transistor T₂, son collecteur à l'émetteur du transistor T₂, une résistance R₄ étant connectée entre la base et l'émetteur du transistor T₄ (sortie S₂). Les résistances R₃ et R₄ ont des valeurs peu élevées (par exemple 700.Ω). Une résistance R_{S2} connectée entre la sortie S₂ et la source d'alimentation V (quelques Volts) permet une sortie en tension.

Ce montage, s'il permet d'augmenter la linéarité de l'étage différentiel, ne conduit nullement, comme le demandeur a pu le constater, à une diminution de la distorsion thermique. En effet, si le courant à travers le trajet collecteur-émetteur des transistors T₁ et T₂ est sensiblement stabilisé, le potentiel de collecteur de ce transistor varie considérablement, ce qui fait, qu'en définitive la puissance dissipée dans les transistors T₁ et T₂ varie en fonction des tensions V₁ et V₂ appliquées sur leur base.

La figure 4 propose selon l'invention un montage permettant d'éliminer les problèmes de distorsion thermique mentionnés ci-dessus. La charge du collecteur des transistor T₁ et T₂ est remplacée par des sources de courant, respectivement I₃ et I₄. Deux transistors T₅ et T₆ de même type que le transistor T₁ et T₂ ont leur base portée à un potentiel de référence V₃ et leurs émetteurs connectés à ceux respectivement des transistors T₃ et T₄. Le collecteur des transistors T₅ et T₆ constitue maintenant les sorties S'₁ et S'₂ de l'étage différentiel (résistances R'_{S1} et R'_{S2}). On remarquera également qu'à titre de variante on a représenté les émetteurs des transistors T₁ et T₂ comme étant couplés par une résistance R₁₂, et connectés chacun à une source de courant, respectivement I₁ et I₂.

Dans ce montage, le courant de contre-réaction est fixé par la différence entre le potentiel du collecteur des transistors T₁ et T₂ et la tension continue de référence V₃. En effet, les transistors T₃ et T₅ et T₄ et T₆ d'autre part de type opposé étant couplés par leurs émetteurs, le courant traversant leur trajet de collecteur-émetteur est fonction de la différence entre les tensions appliquées à leurs bases. D'autre part, le potentiel de collecteur du transistor T₁ (ou T₂) varie peu étant donné qu'il est verrouillé à V₃ - VBE(T₆) - VBE (T₄), VBE désignant la tension base-émetteur d'un transistor. Les tensions de collecteur de T₁ et T₂ varient comme 2 fois la variation des tensions base-émetteur des transistors T₃ et T₅ d'une part et T₄ et T₆ d'autre part. En d'autres termes, le potentiel du collecteur des transistors T₁ et T₂ est pratiquement égal, à une constante donnée près, à la tension de référence. Comme en outre, le courant qui traverse le trajet collecteur-émetteur des transistors T₁ et T₂ est fixé par les sources de courant I₃ et I₄, la puissance dissipée dans les transistors T₁ et T₂, qui est proportionnelle au produit v_{CE} x I_{C} est pratiquement constante (I_{C} désignant le courant de collecteur et V_{CE}, la tension collecteur-émetteur d'un transistor.

Comme le potentiel du collecteur des transistors T₁ et T₂ varie peu, les sources de courant I₃ et I₄ peuvent être remplacées par des résistances de préférence de valeur élevée (par exemple 1 MΩ).

Toute variation du potentiel d'entrée du transistor T₁ (ou T₂) tend à modifier la tension base-émetteur V_{BE} de ce transistor. Cette modification du V_{BE} induit une modification de son courant collecteur. Cette modification de courant se retrouve dans le courant de base du transistor T₃ (ou T₄) puisque la charge du transistor T₁ (ou T₂) présente un courant constant I₃ (ou I₄). La variation du courant de base du transistor T₃ (ou T₄) entraîne une variation de son courant collecteur qui par l'effet de la résistance d'émetteur du transistor T₁ (ou T₂), conduit à reproduire les variations du potentiel d'entrée.

C'est ainsi que la tension émetteur du transistor T₁ (ou T₂) est asservie à sa tension de base avec un décalage constant au premier ordre, puisque c'est le V_{BE} correspondant au courant imposé par la source de courant I₃ (ou I₄).

La distorsion thermique résulte des variations à court terme des températures de jonction des transistors en fonction des signaux. Dans l'art antérieur, les dissipitations modulées par l'amplitude des signaux font varier les caractéristiques des transistors, principalement la tension V_{BE} et le gain en courant. Ainsi, dans le circuit différentiel classique, les variations thermiques de la tension base-émetteur V_{BE} ont directement le même effet qu'une variation du signal d'entrée.

Dans le circuit selon l'invention, la dissipation du transistor T₁ (ou T₂) est stabilisée. Elle n'entraîne donc pas de modulation de la, tension V_{BE}. Le transistor T₃ (ou T₄) travaille avec une tension émetteur-collecteur V_{CE} faible, alors que le transistor T₅ (ou T₆) voit des variations de courant et de tension émetteur-collecteur. Les tensions V_{BE} des transistors T₃ (ou T₄) et T₅ (ou T₆) qui travaillent en courant dans la boucle, ont peu d'effet sur le montage, en raison du faible effet de la variation de la tension émetteur-collecteur du transistor T₁ (ou T₂). Les variations des gains en courant (essentiellement pour le transistor T₅ (ou T₆) utilisé en base commune) ont peu d'effet sur le montage grâce à la boucle de contre-réaction en courant.

La valeur de la tension de référence V₃ est choisie de manière à ce que la tension collecteur-base V_{CB} des transistors T₁ et T₂ soit relativement peu élevée, à savoir inférieure à quelques Volts, de préférence inférieure à 1 Volt et typiquement de l'ordre de 200 à 300 millivolts.

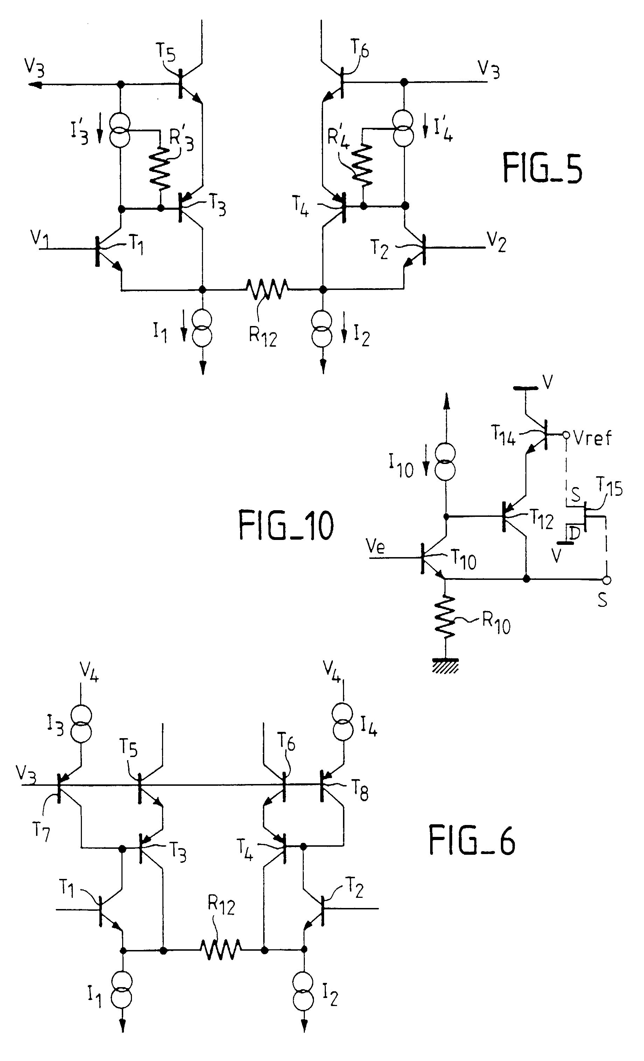

Sur la figure 5, les sources de courant I₃ et I₄ sont remplacées par des sources de courant I'₃ et I'₄ connectées entre la source de tension continue V₃ et le collecteur du transistor, respectivement T₁ et T₄, et dont le courant est commandé par une borne de commande. Des résistances respectivement R'₃ et R'₄ sont connectées entre celles-ci et la base des transistors, respectivement T₃ et T₄.

Sur la figure 6, les sources de courant I₃ et I₄ sont couplées au collecteur des transistors T₁ et T₂ à travers les trajets collecteurs-émetteurs de transistors, respectivement T₇ et T₈ de type opposé au transistor T₁ et T₂ et dont la base est connectée à la source de tension V₃. Les collecteurs des transistors T₁ et T₇ sont interconnectés de même que ceux des transistors T₂ et T₈.

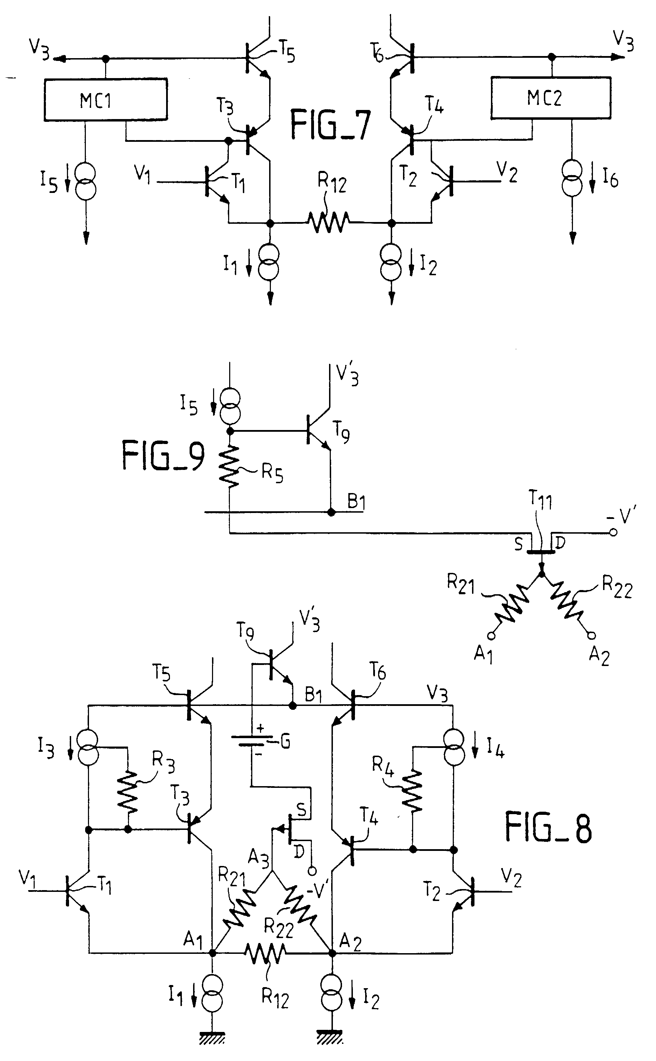

Sur la figure 7, les sources de courant I₃ et I₄ sont réalisées à partir de miroir de courant MC₁ et MC₂ alimentées à partir de deux sources de courant I₅ et I₆ (ou bien à partir d'une source de courant unique).

Etant donné que la dissipation thermique à travers les transistors T₁ et T₂ est liée au produit V_{CE} x I_{E}, la dissipation peut être considérée comme isopuissance seulement pour de faibles variations de V_{E} (jusqu'à environ une centaine de mV pour un étage différentiel). Comme les variations des tensions V₁ et V₂ se retrouvent reproduites sur les émetteurs des transistors T₁, T₂ à une tension V_{BE} près, la présence d'une tension de mode commun dans les signaux d'entrée a pour effet de faire varier la puissance dissipée dans les transistors T₁ et T₂. Le schéma de la figure 8 permet de compenser ce défaut. Pour ce faire, la tension de référence V₃ n'est plus une tension constante, mais elle est asservie à la moyenne des tensions d'émetteur du transistor T₁ et T₂. Pour ce faire, des résistances R₂₁ et R₂₂ de même valeur sont connectées en série entre elles et en parallèle avec la résistance R₁₂ et leur point commun A₃ est connecté à travers un transistor T₁₁ à effet de champ, monté en source suiveuse à la base d'un transistor T₉ dont le collecteur est connecté à une source de tension de référence V'₃ et dont l'émetteur est connecté (B₁) à la base des transistors T₅ et T₆, avec interposition d'un générateur de tension constante G entre le transistor T₁₁ et la base du transistor T₉. Ceci permet de s'affranchir du mode commun en asservissant la tension de base des transistors T₅ et T₆ (tension de référence V₃) sur la moyenne des tensions d'entrée de T₁ et T₂ (à une tension de décalage près, de l'ordre de 2 Volts en pratique). Il en résulte que les variations de la tension collecteur-émetteur des transistors T₁ et T₂ restent négligeables.

On remarquera que les résistances R₂₁ et R₂₂ peuvent avoir des valeurs différentes. D'une manière générale, on asservit la tension de base des transistors T₅ et T₆ à la moyenne pondérée des tensions d'entrée de T₁ et T₂, ce qui permet de tenir compte de leurs particularités éventuelles (par exemple signaux dissymétriques) pour parvenir à un optimum quant aux variations de la puissance dissipée dans T₁ et T₂.

La figure 9 représente un mode de réalisation de la figure 8 dans lequel le générateur de courant G est réalisé par une source de courant I₅ connectée à la base du transistor T₉, une résistance R₅ traversée par ce courant I₅ constant étant connectée entre la base de T₉ et la source du transistor T₁₁.

La figure 10 représente une variante de mise en oeuvre de l'invention dans le cas d'un transistor T₁₀ monté en émetteur suiveur. Une charge est connectée entre l'émetteur de T₁₀ et la masse (ou une tension négative ou nulle). La charge peut être par exemple une résistance R₁₀ ou une source de courant. Une source de courant I₁₀ est connectée au collecteur du transistor T₁₀ alors qu'un transistor T₁₂ de type opposé au transistor T₁₀ a sa base connectée au collecteur de celui-ci, son collecteur connecté à l'émetteur du transistor T₁₀ et son émetteur, à l'émetteur d'un transistor T₁₄, de même type que le transistor T₁₀, et dont le collecteur est connecté à une source de tension d'alimentation V, dont la base est connectée à une source de tension de référence V_{REF}. La source de courant I₁₀ définit le courant à travers le trajet collecteur-émetteur du transistor T₁₀ alors que les deux jonctions base-émetteur en cascade des transistors T₁₄ et T₁₂ de type opposé fixent le potentiel de collecteur du transistor T₁₀ autour V_{REF} - 2 V_{BE}. Le fonctionnement est donc identique quant à la compensation des distorsions thermiques à celui décrit ci-dessus. Les tensions collecteur-base V_{CB} sont également du même ordre de grandeur que pour les transistors T₁ et T₂.

Une variante de la figure 10, mettant en oeuvre à titre d'exemple un transistor T₁₅, dont les connexions sont représentées en pointillés, permet d'asservir la tension de référence V_{REF} par rapport à la tension de sortie S. Un transistor T₁₅ (ici à effet de champ) a son drain connecté à la source de tension d'alimentation V, sa porte à id sortie S (ou à la base de T₁₀ (Vₑ)) et sa source à la base du transistor T₁₄. Ceci permet de maintenir à des niveaux faibles les variations de la tension collecteur-émetteur V_{CE} du transistor T₁₀ même lorsque le potentiel d'entrée Vₑ varie beaucoup.

L'invention ne se limite pas au mode de réalisation spécifiquement décrit et représenté. On a en particulier décrit l'invention avec des transistors de type bipolaire. Il faut bien comprendre que l'invention s'applique également au cas des transistors à effet de champ. Il faut donc considérer que la portée des termes "émetteur", "base" et "collecteur" s'étend également respectivement aux termes "source", "porté" et "drain".
Exemple : V = 15 Volts ; V_{REF} = V₃ = 2 Volts
I₁ = I₂ = 5 mA ; I₃=I₄ = 2,5 mA
R'_{S1} = R'_{S2} = 4 kΩ
R₁₂ = 200Ω

## Revendications

1. Etage amplificateur pour signaux audio comprenant au moins un module présentant un premier transistor d'un premier type de conductivité dont la base constitue une borne d'entrée pour un signal d'entrée et un moyen pour maintenir un courant sensiblement constant dans le trajet collecteur-émetteur du premier transistor et comportant un circuit de contre-réaction (T₃, T₅) présentant un trajet de courant principal entre une borne active (S'1) de l'étage et l'émetteur du premier transistor (T₁, T₁₀), caractérisé en ce que ledit moyen est constitué par une première source de courant (I₃) connectée au collecteur du premier transistor (T₁) et en ce que le circuit de contre-réaction est agencé de manière telle que la valeur dudit courant principal est fonction de la différence entre la tension (V₃) d'une source de tension de référence et le potentiel (VCT₂) du collecteur du premier transistor (T₁), le gain du circuit de contre-réaction étant choisi de manière telle que le potentiel du collecteur du premier transistor (T₁, T₁₀) soit sensiblement constant, et la tension (V₃) de la source de tension de référence n'étant pas liée à la tension d'alimentation et étant choisie de manière que le premier transistor (T₁) fonctionne à tension collecteur-base sensiblement constante.

2. Etage amplificateur selon la revendication 1, caractérisé en ce que ladite tension (V₃) de la source de tension de référence est choisie de manière telle que le premier transistor (T₁) fonctionne à tension collecteur-base peu élevée, en particulier inférieure à 1V.

3. Etage amplificateur selon une des revendications 1 ou 2, caractérisé en ce que le trajet de courant principal du courant de contre-réaction comporte un deuxième transistor (T₃) d'un deuxième type de conductivité opposé au premier type de conductivité, dont le collecteur est connecté à l'émetteur du premier transistor (T₁), dont la base est connectée au collecteur du premier transistor (T₁), et dont l'émetteur est connecté à l'émetteur d'un troisième transistor (T₅) d'un premier type de conductivité, dont la base est connectée à ladite source de tension de référence (V₃), et dont le collecteur constitue ladite borne active de l'étage (S'₁).

4. Etage amplificateur selon la revendication 3, caractérisé en ce que la première source de courant (I'₃) comporte une borne de commande de courant et en ce qu'une première résistance (R'3) est connectée entre ladite borne de commande de la première source de courant (I'₃) entre ladite borne de commande de la première source de courant (I'₃) et la base du deuxième transistor (T₃).

5. Etage amplificateur selon la revendication 3, caractérisé en ce que la première source de courant est constituée par une branche de sortie d'un miroir de courant (MC₁, MC₂).

6. Etage amplificateur selon la revendication 3, caractérisé en ce qu'il comporte un quatrième transistor (T₇) du deuxième type de conductivité dont la base est connectée à celle du troisième transistor (T₅), dont le collecteur est connecté au collecteur du premier transistor (T₁), et dont l'émetteur est connecté à ladite première source de courant (I₃).

7. Etage amplificateur selon une des revendications précédentes, caractérisé en ce qu'il comporte une deuxième source de courant (I₁) connectée à l'émetteur du premier transistor (T₁).

8. Etage amplificateur selon une des revendications précédentes, caractérisé en ce que ladite borne active est une borne d'alimentation en tension (V) de l'étage et en ce que l'étage amplificateur est du type émetteur suiveur.

9. Etage amplificateur selon la revendication 8, caractérisé en ce qu'il comporte un circuit de commande (T₁₅) destiné à asservir la valeur de la tension de la source de tension de référence en fonction de la tension d'émetteur ou de base du premier transistor (T₁₀).

10. Etage amplificateur caractérisé en ce qu'il comporte deux modules selon une des revendications précédentes, les émetteurs du premier transistor de chaque module étant couplés par une impédance (R₁₂) pour former un étage différentiel (T₁, T₂), les bornes actives des deux modules constituant des sorties de l'étage différentiel (T₁, T₂).

11. Etage amplificateur selon la revendication 10, caractérisé en ce qu'il comporte un circuit de compensation (R₂₁, R₂₂, G) destiné à décaler la valeur de la tension de la source de tension de référence (V'₃) en fonction de la tension de mode commun de l'étage différentiel (T₁, T₂).

12. Etage amplificateur selon la revendication 11, caractérisé en ce que le circuit de compensation comporte un pont de résistances (R₂₁, R₂₂) présentant un point milieu (A₃) dont la tension est la moyenne entre les tensions d'émetteur du premier transistor (T₁, T₂) des deux modules et en ce qu'il comporte un cinquième transistor (T₁₁) monté en émetteur suiveur ainsi qu'un générateur de tension constante (G) disposés en série entre ledit point milieu (A₃) et la base d'un sixième transistor (T₉) dont l'émetteur délivre ladite tension (V₃) de la première source de tension continue.

## Patentansprüche

1. Verstärkerstufe für Tonsignale mindestens aus einem Modul mit einem ersten Transistor ersten Leitungstyps bestehend, dessen Basis eine Einführungsklemme für das Eingangssignal sowie eine Vorrichtung zur Aufrechterhaltung von ziemlich gleichbleibendem Strom auf dem Kollektor-Senderweg des ersten Transistors darstellt und außerdem einen Gegenkopplungskreis (T₃, T₅) mit einem Hauptstromweg zwischen der aktiven Klemme (S'1) der Stufe und dem Sender des ersten Transistors (T₁, T₁₀) enthaltend, dadurch gekennzeichnet, daß die genannte Vorrichtung aus einer ersten Stromquelle (I₃) besteht, die mit dem Kollektor des ersten Transistors (T₁) verbunden ist; und daß der Gegenkopplungskreis so angeordnet ist, daß sich der Wert des Hauptstroms aus dem Unterschied zwischen der Spannung (V₃) einer Bezugsspannungsquelle und der Spannung (VCT₂) des Kollektors des ersten Transistors (T₁) ergibt; wobei die Stromverstärkung des Gegenkopplungskreises so gewählt wird, daß die Kollektorspannung des ersten Transistors (T₁, T₁₀) ziemlich konstant ist, und daß die Spannung (V₃) der Bezugsspannungsquelle nicht mit der Netzspannung verbunden ist und so gewählt wird, daß der erste Transistor (T₁) unter ziemlich konstanter Kollektor-Basisspannung läuft.

2. Verstärkerstufe gemäß Anspruch 1, dadurch gekennzeichnet, daß die genannte Spannung (V₃) der Bezugsspannungsquelle so bestimmt wird, daß der erste Transistor (T₁) unter niedriger Kollektor-Basisspannung läuft, die insbesonders unter 1V liegt.

3. Verstärkerstufe gemäß Ansprüchen 1 oder 2, dadurch gekennzeichnet, daß der Hauptstromweg des Gegenkopolungskreises einen zweiten Transistor (T₃) eines zweiten Leitungstyps, der dem ersten Leitungsstyp entgegengesetzt ist, enthält, dessen Kollektor mit dem Sender des ersten Transistors (T₁) verbunden ist, dessen Basis mit dem Kollektor des ersten Transistors (T₁) verbunden ist, und dessen Sender mit dem Sender eines dritten Transistors (T₅) eines ersten Leitungstyps verbunden ist, dessen Basis mit der genannten Bezugsspannungsquelle (V₃) verbunden ist und dessen Kollektor die genannte aktive Klemme der Stufe (S'₁) darstellt.

4. Verstärkerstufe gemäß Anspruch 3, dadurch gekennzeichnet, daß die erste Stromquelle (I'₃) eine Regelungsklemme für den Strom enthält und daß ein erster Widerstand (R'₃) zwischen der genannten Regelungsklemme der ersten Stromquelle (I'₃) und der Basis des zweiten Transistors (T₃) angeschlossen ist.

5. Verstärkerstufe gemäß Anspruch 3, dadurch gekennzeichnet, daß die erste Stromquelle durch den Ausgangszweig eines Stromspiegels (MC₁, MC₂) gebildet wird.

6. Verstärkerstufe gemäß Anspruch 3, dadurch gekennzeichnet, daß sie einen vierten Transistor (T₇) eines zweiten Leitungstyps enthält, dessen Basis mit der des dritten Transistors (T₅) verbunden ist, dessen Kollektor mit dem Kollektor des ersten Transistors (T₁) verbunden ist und dessen Sender mit der genannten ersten Stromquelle (I₃) verbunden ist.

7. Verstärkerstufe gemäß einem der vorigen Ansprüche, dadurch gekennzeichnet, daß sie eine zweite Stromquelle (I1) enthält,die mit dem Sender des ersten Transistors (T₁) verbunden ist.

8. Verstärkerstufe gemäß einem der vorigen Ansprüche, dadurch gekennzeichnet, daß die genannte aktive Klemme eine Anschlußklemme für die Spannung (V) der Stufe ist und daß die Verstärkerstufe vom Typ Sende-Verstärker ist.

9. Verstärkerstufe gemäß Anspruch 8, dadurch gekennzeichnet, daß sie einen Steuerkreis (T₁₅) enthält, der den Spannungswert der Bezugsspannungsquelle im Verhältnis zur Sender- oder Basisspannung des ersten Transistors (T10) bestimmt.

10. Verstärkerstufe gemäß einem der vorigen Ansprüche, dadurch gekennzeichnet, daß sie zwei Module enthält, wobei die Sender des ersten Transistors des jeweiligen Moduls durch einen Widerstand (R₁₂) gekoppelt werden, so daß sie eine differentielle Stufe (T₁, T₂) bilden, wobei die aktiven Klemmen der beiden Module die Ausgänge der differentiellen Stufe (T₁, T₂) bilden.

11. Verstärkerstufe gemäß Anspruch 10, dadurch gekennzeichnet, daß sie einen Ausgleichsstromkreis (R₂₁, R₂₂, G) enthält, der den Spannungswert der Bezugsspannungsquelle (V'₃) im Verhältnis zur Gleichtaktspannung der differentiellen Stufe (T₁, T₂) verschiebt.

12. Verstärkerstufe gemäß Anspruch 11, dadurch gekennzeichnet, daß der Ausgleichsstromkreis eine Widerstandsmeßbrücke (R₂₁, R₂₂) mit einem Mittelpunkt (A₃) enthält, dessen Spannung die Durchschnittsspannung der Senderspannungen des ersten Transistors (T₁, T₂) der beiden Module darstellt und daß sie einen fünften Transistor (T₁₁), der als Sende-Verstärker aufgebaut ist und einen Generator für Konstantspannung (G) enthält, die in Serie zwischen dem genannten Mittelpunkt (A₃) und der Basis eines sechsten Transistors (T₉) angeordnet sind, dessen Sender die genannte Spannung (V₃) der ersten Gleichspannungsquelle liefert.

## Claims

1. Amplifier stage for audio signals, comprising at least one module presenting a first transistor, of a first conduction type, the base of which constitutes an input terminal for an input signal and a means to maintain an appreciably constant current in the collector-emitter path of the first transistor, and including a feedback circuit (T₃, T₅) that provides a main current path between the active terminal (S'₁) of the stage and the emitter of the first transistor (T₁, T₁₀), characterised in that the said means consists of a first current source ((I₃), connected to the collector of the first transistor (T₁) and in that the feedback circuit is connected so that the value of said main current is a function of the difference between the voltage (V₃) of a reference-voltage source and the potential (VCT₂) of the collector of the first transistor (T₁); the feedback circuit gain is selected such that the potential of the collector of the first transistor (T₁, T₁₀) is appreciably constant and the voltage (V₃) of the reference-voltage source is independent of the supply voltage and is selected in order that the first transistor (T₁) function with an appreciably constant collector-base voltage.

2. Amplifier stage according to claim 1, characterised in that the said voltage (V₃) of the reference-voltage source is selected in order that the first transistor (T₁) functions with a low collector-base voltage, in particular lower than 1 V.

3. Amplifier stage according to one of the claims 1 or 2, characterised in that the path of the main current of the feedback current includes a second transistor (T₃), of a second conduction type that is opposed to the first conduction type, whose collector is connected to the emitter of the first transistor (T₁), whose base is connected to the collector of the first transistor (T₁), and whose emitter is connected to the emitter of a third transistor (T₅), of the first conduction type, the base of which is connected to said reference-voltage source (V₃), and the collector of which constitutes said active terminal of the stage (S'₁) .

4. Amplifier stage according to claim 3, characterised in that the first current source (I'₃) includes a current control terminal and in that the first resistor (R'₃) is connected between said control terminal of the first current source (I'3) and the base of the second transistor (T₃).

5. Amplifier stage according to claim 3, characterised in that the first current source is formed by an output branch of a current-mirror (MC₁, MC₂).

6. Amplifier stage according to claim 3, characterised in that said amplifier stage includes a fourth transistor (T₇), of the second conduction type, whose base is connected to that of the third transistor (T₅), whose collector is connected to the collector of the first transistor (T₁), and whose emitter is connected to said first current source (I₃).

7. Amplifier stage according to one of the preceding claims, characterised in that said amplifier stage includes a second current source (I₁) connected to the emitter of the first transistor (T₁).

8. Amplifier stage according to one of the preceding claims, characterised in that said active terminal is the supply-voltage terminal (V) for the stage and in that the amplifier stage is an emitter follower.

9. Amplifier stage according to claim 8, characterised in that said amplifier stage includes a control circuit (T₁₅) designed to keep the value of the voltage of the reference-voltage source a function of either the emitter voltage or the base voltage of the first transistor (T₁₀).

10. Amplifier stage, characterised in that said amplifier stage consists of two modules according to one of the preceding claims, where the emitters of the first transistor of each module are coupled by an impedance (R₁₂) in order to produce a differential stage (T₁, T₂), the active terminals of the two modules constituting the outputs of the differential stage (T₁, T₂).

11. Amplifier stage according to claim 10, characterised in that it includes a compensation circuit (R₂₁, R_{22,} G) designed to shift the value of the voltage of the reference-voltage source (V'₃) as a function of the common-mode voltage of the differential stage (T₁, T₂).

12. Amplifier stage according to claim 11, characterised in that the compensation circuit includes a resistance bridge (R₂₁, R₂₂) that provides a midway point (A₃) where the voltage is the average of the emitter voltages of the first transistor (T₁, T₂) of the two modules, and in that it includes a fifth transistor (T₁₁) as an emitter follower, as well as a constant voltage generator (G) mounted in series between said midway point (A₃) and the base of a sixth transistor (T₉), whose emitter supplies said voltage (V₃) of the first constant voltage source.
